# EUROPEAN PATENT APPLICATION

(11) **EP 4 629 764 A1**
(43) Date of publication of application: **08.10.2025**
(21) Application number: 24186895.9
(22) Date of filing: 05.07.2024
(51) Int. Cl.: H05K 7/20

(54) **LIQUID COOLING SYSTEM WITH FLOW CONTROL BASED ON PER-NODE VALVES**

(30) Priority: 02.04.2024 US 202418624225
(71) Applicant: Hewlett Packard Enterprise Development LP, Spring, TX 77389 (US)
(72) Inventor: KUFAHL, Benjamin John, 50733 Cologne (DE); LUNSMAN, Harvey John, Chippewa Falls, 54729 (US); COLLINS, David Robert, Eau Claire, 54701 (US)
(74) Representative: Marks & Clerk LLP

(57) **Abstract**

A system, a method and device. The system comprising trays each comprising processors, a liquid cooling loop configured to supply liquid coolant to the trays, individually electronically controllable valves disposed in the liquid cooling loop, wherein each valve of comprises a movable element which is movable in response to an electronic signal to control the flow of the liquid coolant to a corresponding tray of the plurality of trays, pumps configured to cause the liquid coolant to flow through the liquid cooling loop, a control system comprising one or more controllers, wherein the controllers are configured to: individually control each valve of the plurality of individually electronically controllable valves as a function of a state of the corresponding tray, and control the pumping speed of the one or more pumps as a function of the states of the movable elements of the individually electronically controllable valves.

## Description

Computing devices generate heat as they operate. As the computing power of those devices increases, so does heat generation. To maintain operational capability and prevent overheating of those devices, cooling solutions that remove that excess heat are needed. For lower capacity computing, air cooling might suffice, but for higher capacity computing liquid cooling may be desired. For example, a liquid cooling solution may include flowing liquid coolant through computing devices, with the liquid coolant capturing heat and removing it from the computing devices. In one common liquid cooling architecture, a closed liquid flow loop may be provided which includes a heat exchanger and infrastructure to circulate liquid coolant in a loop between the heat exchanger and a group of computing devices (e.g., the computing devices in a rack or set of racks). In such a system, cold coolant flows from the heat exchanger through the loop into the computing devices, the coolant absorbs heat from the devices, the now-warmed coolant exits the devices and flows back to the heat exchanger, the heat exchanger removes heat from the coolant by exchanging heat with another cooling medium (e.g., liquid coolant from an outer loop connected to the heat exchanger, cool air, etc.), and then the now-cooled coolant begins the loop again.

In systems that utilize liquid cooling solutions, such as the closed loop liquid cooling, the flow(s) of coolant is(are) delivered through the use of one or more pumps. The pumps are often disposed in a coolant distribution unit (CDU), which may also include the heat exchanger of the loop. Liquid cooling infrastructure such as tubes/pipes, fittings, manifolds, etc. may be connected between the pumps and the electronic devices to form the liquid cooling loop. For example, the coolant liquid may be pumped into a supply manifold which distributes the liquid coolant to multiple devices in the system, and from devices the coolant flows into a return manifold which recombines the flows to return the coolant to the pumps.

### BRIEF DESCRIPTION OF THE DRAWINGS

The present disclosure can be understood from the following detailed description, either alone or together with the accompanying drawings. The drawings are included to provide a further understanding of the present disclosure and are incorporated in and constitute a part of this specification. The drawings illustrate one or more examples of the present teachings and together with the description explain certain principles and operation. In the drawings:
FIG. 1 is a block diagram illustrating an example of a liquid cooling system.
FIG. 2 is an example block diagram illustrating a liquid cooling system with multiple racks.
FIG. 3 is an example view of a supply-side located valve configuration.
FIG. 4 is a process flow illustrating an example method.
FIG. 5 is a block diagram illustrating an example computing system.

The drawings are included to provide a further understanding of the present disclosure and are incorporated in and constitute a part of this specification. The drawings illustrate one or more examples of the present teachings and together with the description explain certain principles and operations. In some occasions, details that are not necessary for an understanding of an instance of this disclosure or that render other details difficult to perceive may have been omitted.

### DETAILED DESCRIPTION

A high-performance computing system or other multi-node computing system may utilize liquid cooling. For example, the computing system may comprise one or more racks or cabinets each comprising multiple trays or blades, which are configured to work together as a single system, and in some instances a liquid cooling system may comprise a liquid cooling loop which circulates liquid coolant through each of the trays or blades.

Generally, the amount of heat that the liquid coolant can remove depends on the flow rate of the liquid coolant, among other things, with greater flow rates allowing for removal of more heat. The flow rate of the liquid coolant may depend on the pump speed of the pumps, with greater pumps speeds requiring larger expenditures of energy to power the pumps. If the pumps are providing flow rates that exceed the amount needed to remove the heat being generated by the computing system, then some of the energy being supplied to the pumps is being wasted. To avoid such waste of energy, some systems may attempt to dynamically control the pump speed such that, at any given time, the overall coolant flow rate is as low as is feasible while still providing adequate cooling to the computing system as a whole.

In some instances, the liquid cooling systems are configured such that the liquid flows through each of the trays or blades at the same rate. In other words, the overall flow rate of liquid through the loop may change over time (e.g., in accordance with the pump speed controls described above), but generally each tray or blade will receive the same proportionate share of that overall flow. These systems may be referred to herein as fixed-share systems. In a fixed-share system, to ensure that trays or blades generating the greatest amounts of heat (e.g., due to experiencing high utilization) receive sufficient cooling, the overall flow rate through the system (and hence, the pump speed) any given time must be set relatively high so as to ensure the hot trays/blades receive coolant at an individual flow rate that enables sufficient cooling. However, in such a situation, the energy expended by the pump to provide the high overall flow rate is wasted on other trays or blades that are generating less heat (e.g., due to experiencing lower demand), because they also receive the high individual flow rate which they do not need. This requirement to supply an overall flow rate for the whole system based on the heat generation needs of the hottest individual tray or blade is inefficient as it wastes energy.

One approach to mitigating the issues described above is to distribute pumps throughout the system, with the pumps being arranged to supply coolant flows in parallel to different sections of the system. For example, a pump may be provided for each tray/blade, or for a group of trays of blades. In those instances, flow may be specifically allocated to each section of the system based on its heat generation. Although this configuration may be more power efficient than a central cooling system alone, this approach may be costly as each section requires a dedicated pump, with respective control logic and power electronics to drive the pump. In addition, this approach can still be wasteful of energy, as multiple distributed pumps may require more energy to provide a given overall flow rate than would be required for a single larger pump to provide the same flow rate.

To address these problems, this disclosure provides a system in which electronically controllable valves are provided to control the flow of liquid coolant through the trays/blades, with the valves being provided on a per tray/blade basis such that the flow rates through the tray/blades can be individually and severally controlled. The valve positions are controlled based on the respective states of the trays/blades to which they supply liquid. Moreover, the system may control the speed of the pump which supplies the liquid coolant to all of the valves based on the respective opening states of the electronically controllable valves (e.g., how open or closed the valves are). Generally, the more open the valves are (as a whole), the greater the pump speed, whereas the more closed the valves are (as a whole), the lower the pump speed. The individually controllable valves can allow high-heat trays/blades to receive a higher liquid flow rate (by opening their valves more) while providing a lower liquid flow rate to low-heat trays/blades (by opening their valves less). In addition, the control of the pump speed based on the valve states may allow for reduction in pump energy consumption when high pump speeds are not needed. Thus, pump energy need not be wasted by providing high flow rates to low-heat trays/blades which do not need the high flow rate.

Furthermore, providing the valves on a per-tray/blade basis may be much less expensive than providing individual pumps on a per-tray/blade basis. Also, the valves may require much less energy than the per-tray pumps, as the valves only consume energy occasionally (e.g., when they are driven to change their opening state), whereas the per-tray pumps may consume energy continually.

In addition, the individually controllable valves can enable effective leak mitigation. When a leak is detected at a given tray/blade, the valve which supplies coolant to that tray/blade can automatically be closed, which prevents further coolant from leaking out. In other words, the individually controllable valves allow for the isolation of a tray/blade (or section of trays/blades) in case of a detected leak. With the leaking tray/blade isolated, the pumps can continue to operate to supply liquid coolant to the rest of the system without concern that doing so will cause liquid to leak out. In contrast, in other approaches, when a leak is detected, the pumps of the coolant loop may need to be turned off in order to depressurize the entire loop and thereby prevent more coolant from leaking out. The entire loop needs to be depressurized because the leaking tray/blade cannot effectively be isolated from the rest of the loop, and thus continued operation of the loop will result in more leakage. The shutting down of the pumps results in the trays/blades needing to be shut down (due to lack of cooling), including those trays which do not have any leak. This issue of needing to shut down the entire system may occur both in systems that use a centralized pumping unit and systems that use distributed pumps.

As noted above, in instances, the pump speed may be adjusted based on the opening state of each valve, wherein opening state refers to the degree of openness of the valve. In some examples, the opening states of the valves may be quantified and aggregated together into a valve openness parameter, and the pump speed may be controlled based on this parameter. For example, each valve's openness may be quantified as a percentage (e.g., 100% is fully open, 0% is fully closed), and the valve openness parameter may comprise an average of the openness values of all the valves. In some examples, the pump speed is controlled such that the greater the degree of openness of the valves, the higher the pump speed, and vice versa. Controlling pump speed based on the individual valve opening states can allow for more efficient operation than controlling pump speed based on overall system temperature or other similar parameters. For example, the pump speed can be ramped down when lower overall flow rates are needed (as indicated by the collective degree to which the valves are open), thus saving power, while still providing needed flow rates to higher powered trays/blades whose valves remain more open. In addition, controlling the pump speed based on the valve states may maintain a constant pressure in the system notwithstanding the changing valve states.

Controlling the pump speed based on the valve states, rather than on some other parameter such as a sensed pressure, may provide more efficient and quicker responses to system changes. This may be the case because other parameters may be lagging, meaning that there may be a delay between the occurrence of an event and the sensing of change in the parameter resulting from the event-for example, there may be a delay between a timing when a valve reduces its openness by some amount and a timing when a pressure sensor registers a resultant change in the pressure in the loop. Because the pump speed is adjusted based on the opening state of the valves, the pump speed may be adjusted simultaneously with or even before the valves are moved, rather than waiting for the effects of the valve state changes (such as pressure changes) to manifest and then reacting to those effects. In an example, a section may experience an increase demand and in response the valve for that section may be opened farther and the pump speed may be increased simultaneously with the movement of the valve. In some instances, pump speed may be adjusted before the movement of the valve. For example, the system may calculate (or look up) the time that the increased flow would take to reach the valve. In this example, the pump may adjust the speed before the valve changes by the time that the flow would take to reach that valve. In other words, the increased flow would reach the section as soon as the valve increases the opening of flow.

As noted above, the valve opening states are controlled based on a status of the tray/blade which they supply liquid to. In some examples, this status may be a sensed temperature of the tray or blade. In these examples, in response to an increase in sensed temperature of a tray/blade, the valve of that tray/blade may be opened by some amount, and in response to a decrease in sensed temperature the valve may be closed by some amount.

In further instances, the status may be some other tray status that is related to the amount of heat generated by the tray. Examples of such tray statuses include: the degree of utilization of the tray/blade, a type of workload of the tray or blade, a frequency of a processor of the tray or blade, a power mode of the tray/blade (e.g., sleep mode, power saver mode, performance mode, etc.), the numbers and/or types of auxiliary devices (such as optical transceivers) plugged into the tray/blade and their statuses, etc. In some cases, these tray statuses may be monitored and the valve states may be changed in response to detecting a change in the tray status, without necessarily waiting for a change in temperature to be sensed. For example, an increase in utilization of the tray/blade may be expected to result in greater heat generation thereof, and thus in response to determining that a utilization of a given tray/blade has increased, the valve openness of that tray/blade may be increased. Controlling the valves based on such tray statuses may allow for changes in coolant flow rates to be effectuated earlier than if the valves were controlled based on other parameters, such as sensed temperature, which may be lagging (i.e., a change in temperature of a tray/blade may not be sensed until sometime after the state change which caused the temperature change).

In addition, in some examples, the controlling of the valve states based on the tray status may include predicting a change in the tray status prior to the change occurring. In other words, the tray statuses mentioned above could include predicted tray statuses, in addition to or in lieu of detected tray statuses. For example, an increase, or decrease, in demand may be predicted by the system. In such instances, a valve and pump speed may be adjusted based on the prediction of increased demand for that section. In an example, Artificial Intelligence algorithms may be used to predict future demand, and adjust pump speed and valves. Adjusting the valve opening states based on predictions of future tray status changes may allow for the adjustments in coolant flow (via closing/opening the valves) to be completed prior to the changes in tray status actually occurring. Each valve takes some finite amount of time to actuate (e.g., for the movable element therein to move between positions) and also once the valve has actuated it takes some finite amount of time for the resultant change in flow rate to propagate through the loop, and therefore if a valve is actuated after, or even at the same time as, a change in the tray occurs which requires increased coolant flow, the tray may lack the increased flow rate it needs for some period of time while waiting for the changes to propagate through the system. However, if the valves are actuated based on a predicted tray status, the arrival of the increased flow rates at the tray can be made closer to the point in time when the need for that increased flow rate starts, thus reducing or potentially eliminating the aforementioned time period between the timing when a tray status changes and the timing when resulting increased flow rate arrives at the tray. For example, if it is predicted that a given tray is about to begin executing a new job, which is expected to increase utilization and therefore require additional coolant flow, the valve of that given tray can begin to open up prior to the job actually beginning such that, at the time when the new job starts to be executed, the valve movement has already been completed and the resulting additional coolant flow is already flowing to the given tray.

In some examples, a pump may be located at the rack level, where only a few sections and their respective valves, are connected to that pump. In examples, a pump may be located at a facility level, such as a data center. Where a pump is located at the facility level, each section of the facility, such as a rack, may have their own valve, with subsections having their own valves. In other instances, continuing with this example, each rack may have its own pump connected to subsection valves.

This disclosure provides many advantages over current approaches, such as increased precision, increased efficiency through less use of resources and isolation of a system in case of leaks without compromising other sections.

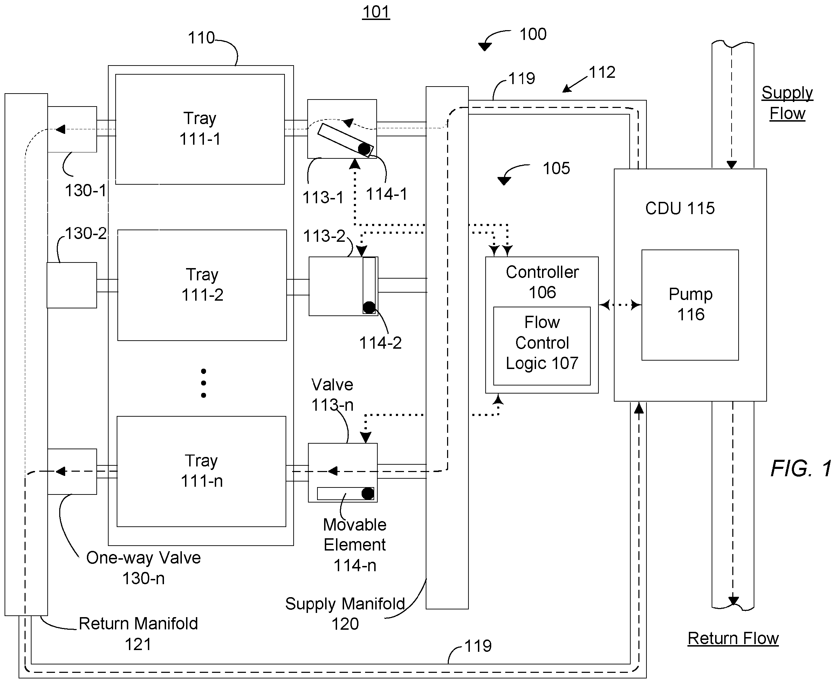

These and other examples will be described in greater detail below in relation to FIGs. 1-5.

Now referring to FIG.1, a liquid cooling system 100 is presented. The liquid cooling system 100 is configured to be used with a computing system 110, and thus FIG. 1 illustrates the system 100 in an installed state with the computing system 110, to facilitate understanding. The computing system 110 and liquid cooling system 100 together form a system 101. However, it should be understood that liquid cooling system 100 and computing system 110 could be provided (manufactured, sold, etc.) seperately and that examples disclosed herein include both examples of the liquid cooling system 100 by itself and examples of the liquid cooling system 100 and the computing system 110 together. In some examples, a component of the computing system 110 may also be part of the liquid cooling system 100, and vice versa. FIG. 1 is schematic in nature and is not intended to illustrate structures accurately or to scale.

As noted above, system 101 may include computing system 110. A "computing system," as used herein, is a system that includes one or more computing devices. In some examples, computing system 111 may include a plurality of computing devices, with FIG. 1 illustrating these computing devices in the form of a plurality of trays 111. A "tray," as used herein, is a modular computing component comprising a chassis and a primary board (e.g., motherboard) with at least one processor node, wherein the tray is designed to fit into a chassis or enclosure of a larger computing system. Trays may interchangeably be referred to as "blades" throughout this disclosure. For example, FIG. 1 illustrates trays 111-1, 111-2, ..., 111-n. In this context, "n" is used as an index representing any integer greater than two which corresponds to the total number of trays 111. For example, in instances there may be eight trays 111 included in computing system 110, in which case n=8. In some examples, the trays 111 may be aggregated together to form a single unified computer system, such as a high-performance compute (HPC) system. In some instances, one of more of the trays 111 may include a baseboard management controller (BMC), in addition to the other components mentioned above.

In some examples, the computing devices of the computing system 110 are not necessarily configured as trays which fit into a larger system chassis or which are aggregated together into a single computer system, but may instead be, for example, individual rack-mount servers which can form separate computing systems. In other words, other types of computing devices may be used in lieu of the trays 111. Each computing device of computing the system 110 (whether a tray 111 or other type of computing device) may comprise at least one processor node.

In examples, computing system 110 may include one or more server racks/cabinets to which the trays 111 (or other computing devices) are mounted. In some examples, the computing system 110 comprises a system chassis/enclosure which is mounted to a rack, and the trays 111 are installed in the system chassis/enclosure and thus are mounted to the rack indirectly. In other examples, the trays 111 (or other computing devices) are mounted to the rack directly. In an example, computing system 110 may comprise a single server rack. In other examples, computing system 110 may include a row of multiple racks. In other examples, computing system 100 may include multiple rows of racks. In examples, computing system 110 may include multiple trays 111 within a rack. In examples, computing system 110 may include multiple trays 111 located across multiple racks. Upon reading this disclosure, one of ordinary skill in the art would appreciate that multiple configurations of trays (or other computing devices) and racks could be included in liquid cooling system 100.

Still referring to FIG. 1, in instances, system 101 comprises a liquid cooling system 100. Liquid cooling system 100 includes liquid cooling loop 112. In addition, the liquid cooling system 100 comprises a control system 105, which comprises a plurality of individually electronically controllable valves 113-1, 113-b and 113-n, a CDU 115 having one or more pumps 116, and at least one controller 106 configured to control the valves 113 and the pump(s) 116.

Liquid cooling loop 112 is configured to deliver liquid coolant to the liquid cooling system 100 and is hydraulically connected to the trays 111-1, 111-2 and 111-n. As used herein, a "liquid cooling loop" is an assembly of liquid colling infrastructure which forms liquid coolant flow paths for circulating liquid coolant in a closed loop through a computing system for cooling computer hardware thereof. The liquid cooling infrastructure which forms the liquid cooling loop 112 may include pipes 119, fittings (not illustrated), quick-disconnect (QD) couplings (not illustrated), and other infrastructure as would be familiar to those of ordinary skill in the art. Some components of the control system 105, such as the valves 113 and pump(s) 116, may also make up portions of the liquid cooling loop 112. Furthermore, in some instances, the liquid cooling infrastructure making up the liquid cooling loop 112 may include a supply manifold 120, a return manifold 121 and one or more one-way valves 130-1, 130-2 and 130-n.

In examples, liquid cooling loop 112 may be configured to cool one or more trays 111 within a rack. In examples, liquid cooling loop 112 may be configured to cool a plurality of trays 111 within two or more racks. In examples, liquid cooling loop 112 may be connected to two rows of racks. The liquid cooling loop 112 may thus include a plurality of path segments which flow through the plurality of trays 111, respectively. That is, the liquid cooling loop 112 may begin as a single coolant supply flow path exiting the pump(s) 116 of CDU 115, then may subsequently split into multiple path segments corresponding to the trays 111, respectively-the supply manifold 120, for example, may split the coolant flow into these multiple path segments. These path segments may then flow into the respective trays 111, absorb heat therefrom, and then exit the trays 111. After the heated coolant exits the trays 111, the multiple path segments may be recombined back into a single coolant return flow path-the return manifold 121, for example, may recombine the separate coolant flows into the single coolant return flow. The coolant return flow then returns to the CDU 115, where heat can be removed, and the loop may be traversed again. Heat may be removed from the coolant in cooling loop 112 at the CDU 115 by a heat exchanger (not illustrated), such as a liquid-to-liquid heat exchanger which transfers heat to a facility liquid coolant (as illustrated in FIG. 1), a liquid-to-air heat exchanger, or some other heat exchange device.

As noted above, the liquid cooling loop 112 extends through each tray 111 to remove heat therefrom. In some instances, liquid cooling loop 112 may include direct liquid cooling (DLC) architecture, in which one or more cold plates is thermally coupled to the processor and/or other components which need cooling. The cold plates are also thermally coupled to the liquid coolant-for example, the liquid coolant may flow through the cold plates-and therefore heat can be transferred from the components into the liquid coolant via the cold plate. In some examples, the liquid cooling loop 112 may include a Direct-to-Chip (D2C) configuration in which the cooling liquid is contacted directly to the component being cooled, via a chamber or similar structure which surrounds the component to be cooled and into which coolant flows. A person with ordinary skill in the art, upon reading this disclosure, will appreciate the multiple types of cooling configurations included in liquid cooling loop 112.

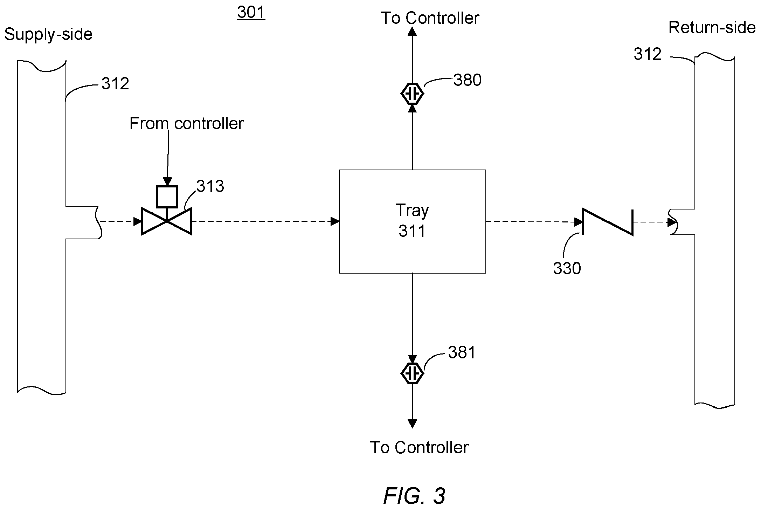

Continuing to refer to FIG. 1, as noted above control system 105 includes a plurality of individually electronically controlled valves 113-1, 113-2 and 113-n. As used herein, an "individually electronically controlled valve" is an electronically actuated valve connected to liquid cooling loop 112 which can be actuated individually (i.e., independently of the other valves) by an electronic signal. In instances, each tray 111 may include, or be connected to, at least one corresponding individually electronically controlled valve 113. For example, the first tray 111-1 may be connected to a first valve 113-1, the second tray 111-2 may be to a second valve 113-2, and so on up to the n^{th} tray 111-n which may be connected to an n^{th} valve 113-n. In some instances, a single tray 111 may be connected to multiple corresponding individually electronically controlled valves 113. For example, in an instance, a tray 111 may be connected to one individually electronically controlled valve 113 configured to allow coolant passage for cooling tray components, such as hard drives and GPU, and to another individually electronically controlled valve 113 for cooling a processor. In some instances, controller 106, which is described in greater detail below, may be connected to at least one sensor. Sensors may include temperature sensors, pressure sensors, leak detection sensors, and the like. Temperature sensors and leak detection sensors are discussed in more detail in reference to FIG. 3.

In instances, each valve of individually electronically controlled valves 113-1, 113-2 and 113-n includes respective movable elements 114-1, 114-2 and 114-n. For example, where liquid cooling system 100 includes eight individually electronically controlled valves 113, in which case n=8, individually electronically controlled valve 113-8 would include respective movable element 114-8. The moveable element 114 may be the part within the valve which is movable to selectively obstruct the flow path through the valve and thus control the flow of coolant through the valve. Changing a position of the movable element 114 changes the size (area) of an opening through the valve through which liquid flows, and thus changes a flow rate through the valves. The movable element 114 may move by rotation (such as a ball in a ball valve, a disc in a butterfly valve, etc.), by translation (such as a gate in a gate valve, a needle in a needle valve, etc.), by deformation (such as a diaphragm in a diaphragm valve), or any other type of motion. In instances, movable elements 114-1, 114-2 and 114-n are movable in response to an electronic signal to control the flow of the liquid coolant to a corresponding tray 111 of the plurality of trays 111-1, 111-2 and 111-n. In instances, individually electronically controlled valves 113 are configured to transmit position feedback. A "position feedback," as used herein, is a signal indicating the position of movable element 114, or other data, within individually electronically controlled valve 113. Positions of the movable element 114 may include a fully open position corresponding to a greatest area of the opening in the valve, a fully closed position corresponding to a small area of the opening in the valve 113, and plural intermediate positions between the fully open position and the fully closed position corresponding to intermediate areas of the opening in the valve 113. The positions may be rotational positions in examples in which the movable element 114 rotates, translational positions in examples in which the movable element 114 translates, and so on. In some examples, the position feedback may indicate the position of the movable element directly, such as by indicating an angle of rotation or a translational distance relative to some reference point. In other examples, the position feedback may include a value from which the position of the movable element 114 can be inferred but which does not directly represent the position, such as a percentage value. In instances, individually electronically controlled valve 113 may be configured to transmit position feedback to the controller 106, which is described in greater detail below. The position feedback may include analog signals, digital signals, communication protocols, and the like.

In instances, coolant flow through a given tray 111 is controlled by controlling the opening state of individually electronically controlled valve 113. In instances, the position feedback mentioned above may include information indicating an opening state. An "opening state," as used herein, is a position of movable element 114 in relative to liquid cooling loop 112 for allowing flow of liquid. For example, in instances, an opening state of "fully closed position," or 0%, means that no flow of liquid is allowed through individually electronically controlled valve 113. In another example, an opening state of "fully open position," or 100%, means that individually electronically controlled valve 113 allows for liquid flow at the full capacity of the valve 113. In examples, an opening state of "partially open position" means that individually electronically controlled valve 113 allows for liquid flow at a position within any range between closed and open. For example, an opening state of 40% means that individually electronically controlled valve 113 allows for liquid to flow at 40% capacity of valve 113. In some examples, such as when a tray is in idled mode, an opening state of "closed position" means that individually electronically controlled valve 113 only allows for liquid flow that is sufficient to provide cooling to an idled tray 111, such as a tray on stand-by. In some examples, a "closed position" may be above 0% but below 1 % of capacity of valve 113.

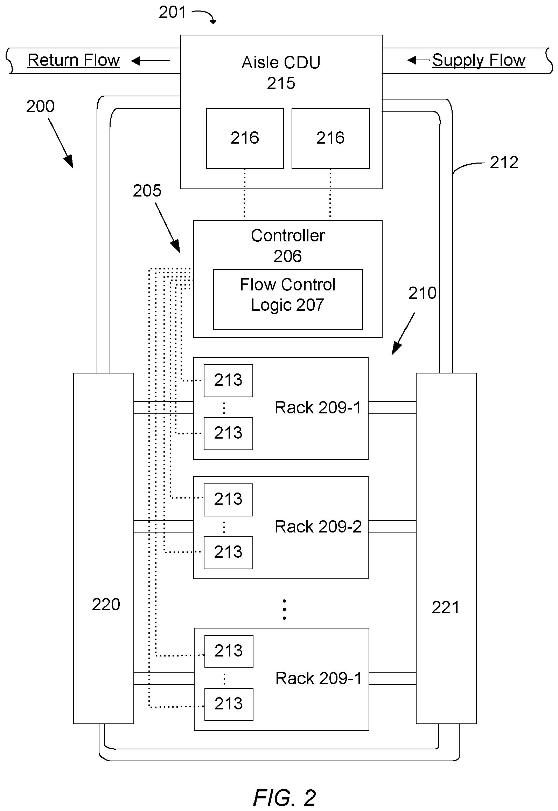

Still referring to FIG. 1, in instances, liquid cooling system 100 includes a cooling distribution unit (CDU) 115. A "CDU," as used herein, is a system, or component, designed and configured to manage and distribute cooling for cooling hardware components. CDU 115 may include rack CDU, row CDU, in-row CDU, facility CDU, and the like. In instances, CDU 115 may be located within a rack. In some instances, CDU 115 may be proximately located, and connected to, a rack. In some examples, CDU 115 may be attached to the chassis of a rack. A "chassis," as used herein, is an enclosure designed to house and support hardware components. In instances, CDU 115 may be a row CDU. In examples, CDU 115 may be located between rows of racks. In some instances, CDU may be an in-row CDU. In examples, CDU 115 may be located within a row that includes multiple racks. In some instances, CDU 115 may be a facility CDU. As used herein, a "facility" is a system that includes multiple rows of racks. In some instances, a facility may include multiple racks not organized in row configuration, such as multiple racks spread out throughout an area. A person with ordinary skill in the art, upon reading this disclosure, will appreciate the many configurations possible for CDU 115 not discussed herein. Muti-rack configurations of liquid cooling system 100 are discussed in more detail in reference to FIG. 2.

In instances, CDU 115 includes one or more pumps 116. In instances, one or more pumps 116 may be configured to circulate coolant liquid through liquid cooling loop 112. In instances, one or more pumps 116 are configured to adjust pumping speed. Pump 116 may include recirculation pumps, variable speed pumps, regenerative turbine pumps, axial flow pumps, MagLev pumps, multistage pumps, positive displacement pumps, centrifugal pumps, and the like.

Continuing to refer to FIG. 1, in instances, liquid cooling system 100 may include one or more one-way valves 130-1, 130-2 and 130-n. Each one-way valve of the one or more one-way valves 130-(1-n), may be disposed on a return a return flow associated with their respective one or more individually electronically controllable valves 113-(1-n). A "one-way valve," as used herein, is a valve that only allows flow of liquid in one direction. In examples, one-way valve 130 may include inline check valves, diaphragm check valves, ball check valves, swing check valves, pressure-relief check valves, axial check valves, and the like.

With continued reference to FIG. 1, in instances, liquid cooling system 100 may include a supply manifold 120. A "supply manifold," as used herein, is a portion of the coolant loop 112 which divides an input liquid flow into multiple outlet flows. As one example, a supply manifold 120 may comprise a single purpose-built component which has an interior fluid chamber, an inlet coupling, and multiple outlet couplings. As another example, a supply manifold 120 may be formed as an assembly of multiple discrete components, such as a series of T- or Y- couplings connected together. In some examples, supply manifold 120 may receive liquid from one or more pumps 116. In an example, supply manifold 120 may be located within or adjacent to a rack. In examples, supply manifold 120 may be connected to one or more trays 111. Although only one supply manifold 120 is illustrated, in some instances, multiple supply manifolds 120 may be included. In an example, supply manifold 120 may be connected to one or more racks. In a further example, multiple supply manifolds 120 may be connected to multiple racks, where each rack may include a corresponding supply manifold 120 connected to one or more trays 111.

In instances, still referring to FIG. 1, liquid cooling system 100 may include a return manifold 121. As used herein, a "return manifold," may be a portion of the coolant loop 112 which combines multiple input liquid flows into a single outlet flow. In examples, return manifold 121 may be connected to one or more trays 111. Although only one return manifold 121 is illustrated, in some instances, multiple return manifolds 121 may be included. In an example, return manifold 121 may be connected to one or more racks. In a further example, multiple return manifolds 121 may be connected to multiple racks, where each rack may include return manifold 121 connected to one or more trays 111.

As noted above, flow control system 105 comprises a controller 106. Controller 106 includes flow control logic 107. As used herein, "logic" refers to processing circuitry configured to perform specified functions. This processing circuitry may include one or more processors together with instructions stored in a computer readable medium which are executable by the processor(s) to cause the performance of the specified functions; or dedicated hardware configured to perform the functions (e.g., a discrete logic circuit, an Application Specific Integrated Circuit (ASIC), Field Programable Gate Array (FPGA), Complex Programable Logic Device (CPLD), etc.); or some combination of these. The flow control logic 107 is configured to perform the functions described herein related to controlling the valves 113 based on the statuses of the corresponding trays 111 and controlling the speed of pump 116 based on the openness states of the valves 113, as will be described in greater detail below. Controller 106 is communicably connected with each of the valves 113 and with the pump 116 such that control signals generated by the controller 106 can control the valves 113 and the pump 116 and such that pump speed information and valve openness information can be fed back to the controller 106. In addition, controller 106 is communicably connected with the trays 111, or with some other device which is in turn connected to the trays 111, such that the controller 106 can receive tray status information about the trays 111.

The controller 106 may be located anywhere in system 100. In addition, although controller 106 is shown as a single component for illustrative purposes, controller 106 may include a plurality of separate processing resources (e.g., processors, microcontrollers, logic circuits, etc.) which may work together to collectively perform the operations of the controller 106 (e.g., one processor may perform one operation, while another processor performs another operation). Moreover, in those instances in which the controller 106 is formed by multiple separate processing resources, those processing resources may be co-located or distributed across multiple locations within system 101. Furthermore, although the controller 106 can be provided as separate unit which is dedicated to flow control operations, this need not be the case and in some examples the controller 106 may be formed from processing resources which are part of other components of system 100 and/or which have other additional functions to perform.

For example, in some implementations controller 106 may be included as part of computing system 110, such as in one or more of the trays 111, in a rack controller (not illustrated), in a system or chassis controller (not illustrated), in a job scheduler (not illustrated), or in any other component of the computing system 110. For example, without limitations, in some implementations the controller 106 may be instantiated, in whole or in part, by a component within one or more trays 111, such as a CPU, a GPU, a Baseboard Management Controller (BMC), or any other processing circuitry.

As another example, in some implementations controller may be included in any part of liquid cooling system 110. For instance, controller 106 may be included in CDU 115, such as in a CDU control unit (not illustrated) or in a pump controller (not illustrated) of pump 116. The controller 106 may also be instantiated, in whole or in part, by one or more microcontrollers (or other processing circuitry) provided in each of the valves 113.

In some examples, the controller 106 may be provided as part of both the computing system 110 and as part of the liquid cooling system 100. For example, portions of the flow control logic 107 which monitor and control the valves 113 may be provided by processing circuitry of the trays 111 (e.g., each tray 111 may control its corresponding valve(s) 113), while portions of the flow control logic 107 which control the pump speed may be provided by some other processing circuitry, such as a rack controller, a CDU control unit, etc..

In some examples, controller 106 may be provided, in whole or in part, in a dedicated unit, which is not part of any of the other components.

In some instances, controller 106 may be connected to components external to system 101, such as an external monitoring component.

As described above, in instances, controller 106 is connected to one or more pumps 116. In some instances, controller 106 is connected to one or more individually controllable valves 113. In some instances, each individually controllable valve 1113 may be connected to its own dedicated processing resource (e.g., microcontroller) which forms part of controller 106. In instances, multiple processing resources which form parts of the controller 106 may be connected to multiple individually controllable valves 113. In a nonlimiting example, each two individually controllable valves 113 may share one processing resource which forms part of the controller 106. In some examples, without limitations, all individually controllable valves 113 may be connected to a single processing resource which forms all or part of controller 106. In some nonlimiting examples, one individually controllable valve 113 may be connected to two or more processing resources which make up part of controller 106, such as an individually controllable valve 113 that is connected to a processing resource of a tray 111 and a rack controller, which together make up part or all of controller 106. One of ordinary skills in the art, upon reading this disclosure, would appreciate the many combinations of individually controllable valves 113 and controllers 106 possible in system 101.

In instances, individually electronically controlled valve 113 may be configured to transmit position feedback to the controller 106. In examples, each individually electronically controlled valve 113 may be configured to transmit position feedback to a BMC connected to its respective tray 111.

In instances, controller 106 may be connected to one or more sensors, as described further above. For example, controller 106 is configured to receive statuses of the trays 111, such as changes in temperature of the trays 111. Based on the statuses of the trays 111, the flow control logic 107 controls the openness states of the valves 113, with each valve 113 being controlled based on the status of its corresponding tray 111.

Specifically, in examples in which the status of the trays 111 is a sensed temperature, the flow control logic 107 may increase the openness of a valve in response to increasing temperature and decrease the openness of the valve in response to decreasing temperature. In some examples, the amount by which a given valve is opened or closed is determined such that the resulting rate of liquid flow through the corresponding tray will provide a desired degree of cooling for the tray in view of its temperature. In some examples, relationships between sensed temperature (or changes therein) and corresponding optimal valve states (or changes in valve state) may be determined in advance and stored (e.g., in a look up table), and then in response to receiving information about a sensed temperature (or change therein) of a given tray 111, the flow control logic 107 may identify an optimal valve openness state (or change therein) for that given tray 111 by consulting the stored values. In other examples, a formula or function which relates sensed temperature to valve openness states (similar to a fan speed curve, except with valve openness being the dependent variable instead of fan speed) may be determined in advance, and then in response to receiving information about a sensed temperature (or change therein) of a given tray 111, the flow control logic 107 may identify an optimal valve openness state (or change therein) for that given tray 111 by calculating the value using the formula/function.

In addition, controller 106 is configured to monitor the openness states of the valves 113 and to control the speed of pump 116 based on the collective openness of the valves 113. Specifically, the flow control logic 107 may increase the pump speed in response to any valve 113 having its openness state increased and may decrease the pump speed in response to any valve 113 having its openness state decreased. In some examples, the amount of increase or decrease in pump speed may be determined based on the change in valve state such that a pressure in the cooling loop 112 remains at (or close to) a desired level. In some examples, this mode of control allows the pressure in the system to remain fairly constant, notwithstanding all the continually changing valve states, without the system having to actively sense the pressure and react to its changes. This may also allow for faster reactions, as there is no need to wait for a pressure change to be sensed before pump speed is adjusted. Furthermore, controlling pump speed based on sensed pressure may result in pressure spikes or drops or oscillation of pump speeds, whereas control of the pump speed based on the valve states can avoid or reduce such occurrences. The optimal pump speeds to use may be determined by the flow control logic 107 based on the valve states by consulting preset values stored in advance or by calculation from a formula or function.

For example, if it is assumed that flow control logic 107 receives a sensor signal indicating a decrease in temperature of tray 111-1 an amount "x", in response flow control logic 107 causes controller 106 to send a signal to individually controllable valve 113-1 to reduce the opening state of movable element 114-1 by an amount "y". The amount of change "y" in valve opening state, in view of the change in temperature "x", may be identified by the flow control logic 107 based on preset values, such as in a lookup table, and/or may be dynamically calculated by controller 106. Upon receiving a signal representing the reduction in opening state of movable element 114-1 by amount "y", flow control logic 107 causes controller 106 to send a signal to one or more pumps 116 to reduce pumping speed by an amount "z" based on the reduction of the opening state. Similarly, this change of pumping speed "z" in view of valve openness reduction "y" may also be identified from preset values and/or calculated by controller 106. As described above, controller 106 may include one or more controllers 106. In this example, controller 106 responsible for effecting the change in opening state may be a rack controller while the controller 106 responsible for effecting the change in pumping speed may be a CDU 115 controller.

Continuing this example, if it is assumed that controller 106 receives a signal of the temperature of tray 111-2 being below a threshold value, the flow control logic 107 may determine that the corresponding valve 113-2 should be closed. This may be the case because a temperature below the threshold indicates that cooling is not needed, for example because the tray is not in use. Upon receiving the temperature signal (or some other signal from the sensor indicating that the tray 111-2 is not in use), flow control logic 107 causes controller 106 to send a signal to individually controllable valve 113-2 to set opening state of movable element 114-2 to closed. Upon receiving a signal representing the reduction in opening state of movable element 114-2, flow control logic 107 causes controller 106 to send a signal to one or more pumps 116 to reduce pumping speed based on the reduction of the opening state. It is noted that "closed" is used herein to indicate that some small amounts of liquid coolant may still be allowed through as to provide cooling to a tray 111 in an idled state. For example, some small amounts of liquid coolant may still be required while a tray is on stand-by.

In another example, upon receiving a leak detection signal from a sensor in tray 111-2, flow control logic 107 causes controller 106 to send a signal to individually controllable valve 113-2 to set opening state of movable element 114-2 to fully closed as to prevent further leaks. In turn, flow control logic 107 causes controller 106 to send a signal to one or more pumps 116 to reduce pumping speed. It is noted that "fully closed" is used herein to indicate that valve is completely shut as to prevent further leaks.

Continuing on this example, if it is assumed that controller 106 receives a signal from a sensor connected to tray 111-n of an increase in temperature for tray 111-n by an amount "a", then in response the flow control logic 107 may determine an amount "b" by which to increase the valve opens of the corresponding valve 113-n. The amount "b" may be determined based on the amount "a" by consulting preset values (e.g. in a lookup table) or by calculation from a formula. Upon receiving the signal of temperature increase, flow control logic 107 causes controller 106 to send a signal to individually controllable valve 113-n to increase the opening state of movable element 114-n, which in this case the opening corresponds to the capacity of the valve, which is an opening state of fully open. In this example, flow control logic 107 causes controller 106 to send a signal to one or more pumps 116 to increase the pumping speed. As described above, controller 106 may include one or more controllers 106.

In instances, continuing to refer to FIG.1, controller 106 may be configured to monitor leaks. In instances, controller 106 may be further configured to set movable elements 114 of individually electronically controlled valves 113 to a fully closed position based on detecting a leak. For example, in instances, controller 106 may set movable element 114-2 of individually electronically controlled valve 113-2 after detecting a leak at tray 111-2. In this example, flow control system through controller 106 reduces the detrimental effect of the detected leak to other components of the system by stopping the flow of liquid to the leaking tray 111.

In some instances, position feedback may include a detected leak signal. In an example, controller 106 may receive a detected leak signal from a sensor connected to an individually electronically controlled valve 113. For example, a sensor may transmit position feedback of individually electronically controlled valve 113 that includes the position of movable element 114 and a leak detection signal. In examples, individually electronically controlled valve 113 may transmit position feedback that includes a leak detection signal, where controller 106 and/or CDU 115 will cause one or more pumps 116 to stop pumping coolant to the affected tray 111. In instances, a leak detection signal will override any other signals transmitted by an individually electronically controlled valve 113. For example, where position feedback includes an opening state and a leak detection signal, controller 106 and/or CDU 115 will treat that individually electronically controlled valve 113 as if it had a fully closed opening state. In this example, flow control logic 107 causes controller 106 to send simultaneous signals to set individually electronically controlled valve 113 into a fully closed position and reduce pumping speed of at least one pump 116 A person of ordinary skill in the art, upon reading this disclosure, will understand that it is imperative that pumping of liquid into a leaking tray is stopped as soon as a leak is detected as to prevent further leaking into the system.

In instances, controller 106 may be configured to set movable elements 114 of individually electronically controlled valves 113 based on a task scheduler. For example, controller 106 may be configured to set movable element 114-2 of individually electronically controlled valve 113-2 to fully open position at a set date and time, such as during times of expected high usage of tray 112-2.

In some instances, controller 106 may be configured to calculate a liquid flow delay between CDU 115 and an individually electronically controlled valve 113. A "liquid flow delay," as used herein, is the amount of time the coolant takes to traverse liquid cooling loop 112 from a pump 116 to an individually electronically controlled valve 113 based on a set pumping speed. For example, in instances, controller 106 may be configured to set movable element 114-2 of individually electronically controlled valve 113-2 to partially open position at 60% from a 20% position, where controller 106 and or CDU 115 may increase pump 116 speed within the calculated liquid flow delay prior to the increase in opening state of individually electronically controlled valve 113-2.

Still referring to FIG.1, in this nonlimiting example, the path of liquid coolant pumped by one or more pumps 116 from CDU 115 through liquid cooling loop 112, supply manifold 120, trays 111-1 and 111-n, including their respective individually electronically controlled valves 113, movable elements 114 and one-way valves 130, return manifold 121 and back to CDU 115 is illustrated in dashed lines. In this nonlimiting example, movable element 114-1 of individually electronically controlled valve 113 is set at an opening state of partially open. In this example, the flow through tray 111-1 is reduced based on the position of movable element 114-1.

Continuing on this nonlimiting example, tray 111-2 receives no liquid coolant due to movable element 114-2 of individually electronically controlled valve 113-2 being at an opening state of fully closed. One of ordinary skill in the art, based on this disclosure, will understand that opening state of closed could be based on multiple conditions, such as disconnection of tray 111-2 or a detected leak at tray 111-2.

Still on this nonlimiting example, tray 111-n receives the full flow of liquid coolant loop 112 due to movable element 114-n of individually electronically controlled valve 113-n being set at opening state of open. Upon reading this disclosure, a person of ordinary skill in the art will appreciate that the flow into 111-n tray will remain constant regardless of the positioning of movable elements 114 of other individually electronically controlled valves 113, at least because the pumps will adjust their pumping speed based on opening states of movable elements 114. As such, as other movable elements 114 change their opening states, the one or more pumps 116 will change their pumping speeds accordingly.

In instances, controller 106 may be configured to set movable elements 114 of individually electronically controlled valves 113 based on a state prediction. A "state prediction," as used herein, is a predicted opening state of one or more movable elements 114 of respective individually electronically controlled valves 113. In some instances, state prediction may include predicted conditions of a tray 111. In instances, state prediction may be an output of a machine learning model. The machine learning model may include regression models, classification models, clustering models, and the like. In some instances, state predictions may be generated using a plurality of models. For example, without limitations, a classification model may be used to label tray usage to timestamps, and subsequentially a regression model may be used for predicting future tray usage (e.g. the state prediction of the trays 111) based on the classified data.

In some instances, controller 106 may be configured to generate a state prediction. In instances, controller 106 may generate a state prediction using a machine learning model. In instances, controller 106 may be configured to train a machine model using training data. In some instances, controller 106 may receive training data. In some instances, controller 106 may generate training data based on data from prior usage of liquid cooling system 100. For example, without limitations, controller 106 may correlate prior usage of trays 111 to timestamps to generate training data.

In instances, controller 106 may be configured to generate a valve performance prediction. As used herein, a "valve performance prediction" is a predicted operational performance status of one or more individually controlled valves 113. For example, the valve performance prediction may include a predicted decrease in the performance of one or more individually controlled valves 113. In some examples, the valve performance prediction may include a predicted failure or malfunction of one or more individually controlled valves 113. The valve performance prediction may be generated based on expected valve runtime hours, actual valve runtime hours, comparisons of valve opening states to tray 111 measurements, and the like. In some instances, comparisons of valve opening states to tray 111 measurements may be included in a time series. For example, a valve performance prediction may be generated by comparing an opening state and tray 111 measurement at time t₀ to an opening state and tray 111 measurement at time t_{1.} In this example, if the opening state is constant between t₀ and t₁, but the measurement of tray 111 is not, such as a higher temperature measurement at t₁, this may indicate that the performance of the respective individually controlled valve 113 is decreasing. If at another time t₂, the tray 111 measurement, such as temperature, continues to increase while the opening state remains constant, controller 106 may generate a valve predicted performance status, such as a prediction of degradation of performance of the respective individually controlled valve 113 for a time tₙ. In some examples, valve performance prediction may include a prediction of failure of the valve.

In some instances, controller 106 may generate valve performance prediction as using of a machine learning model. In instances, generating the valve performance prediction may include training a machine learning model using training data. For example, training data may include correlations opening states to tray 111 measurements. In examples, training data may include correlations within a time series, such as described above. In examples, generating the valve performance prediction using a machine learning model may include predicting a failure of an individually controlled valve 113. In instances, controller 106 may be configured to generate state prediction based on a valve performance prediction. Controller 106 may adjust a state prediction based on a valve performance prediction. For example, if controller predicts a reduction of performance of an individually controller valve 113 at a time tₙ, controller 106 may adjust the opening state prediction accordingly, such as predicting that valve may required a wider opening state due to is reduced performance in order to provide the required cooling to its respective tray 111. Controller 106 may use any machine learning algorithm described throughout this disclosure to generate valve performance predictions.

In the schematic diagram of FIG. 1, the valves 113 are illustrated upstream (on the supply-side) of the trays 111 while one-way valves 130 are illustrated downstream (on the return-side) of the trays 111. However, this placement of the valves 130 was shown merely for ease of illustration, and the valves 113 and 130 could be positioned differently. In particular, as long as the valves 113 can individually control the flow of liquid through their respectively corresponding trays, their placement is not limited. For example, the valves 113 may be upstream of the trays, downstream of the trays 111, or disposed inside the trays, as a few examples. FIG. 3 describe a supply-side configuration in greater detail below. In addition, valves 113 may be omitted in other examples or placed in other locations.

Now referring to FIG. 2, an example system 201 with multiple racks is presented. System 201 is an example implementation of system 101 and comprises a computing system 210 and a liquid cooling system 200. The computing system 210 is one example implementation of the computing system 110 described above in which two or more racks 209-(1-n) are provided. In instances, each of racks 209-(1-n) may comprise a plurality of computing devices (e.g., trays 111) similar to those shown above in relation to computing system 110, which are omitted in FIG.2 for illustration purposes. As used above, "n" is an integer used to refer to the total number, such as in a system with 8 racks, the eight rack is described as rack 209-8.

In this example, without limitations, system 201 includes an aisle CDU 215. As used herein, an "aisle CDU" is a CDU configured to connect to two or more racks 209. Aisle CDU 215 may be consistent with CDU 115 described throughout this disclosure. Liquid cooling system 200 includes liquid cooling loop 212 connected to one or more racks 209, supply manifold 220, return manifold 221, CDU 215 and one or more pumps 216. In instances, supply manifold 220 is used to distribute liquid coolant to one or more racks 209. In instances, each rack 209 may also include an individual supply manifold, such as supply manifold 110, for distributing coolant for each tray inside rack 209. Similarly, return manifold 221 is used for receiving returned liquid coolant from racks 210, where each rack 210 may also include a return manifold for each tray, such as return manifold 121.

Continuing this example, in instances, each rack 209 includes one or more individually electronically controlled valves 213 (which may be examples of individually electronically controlled valves 113). In instances, system 201 includes a flow control system 205, which includes a controller 206. Controller 206 includes a flow control logic 207. Control system 205, controller 206 and flow control logic 207 may be examples of respective flow control system 105, controller 106 and flow control logic 107. Controller 206 is communicably connected to pumps 216 and to individually electronically controlled valves 213. In examples, controller 206 may be communicably connected to components of computing devices, omitted for illustrative purposes, within racks 209.

Now referring to FIG. 3, an example of a portion of a system 301 with a supply-side located valve configuration is presented. System 301 with supply-side located valve configuration is an example implementation of system 101. System 301 with supply-side located valve configuration includes some components which correspond to components of system 101, and these components are given similar reference numbers having the same last two digits, such as 113 and 313. Although system 301 with supply-side located valve configuration is one example of a configuration in system 101, system 101 is not limited to the front located valve configuration. FIG. 3 shows only a portion of the system 301 corresponding to a single tray 311 and the liquid cooling infrastructure which flows liquid coolant therethrough, but it should be understood that the system 301 may also include additional trays, additional liquid cooling infrastructure, and other components (e.g., a controller) which are not illustrated in FIG. 3 but which correspond to components illustrated in FIG. 1.

In this nonlimiting example, system 301 includes tray 311, liquid cooling loop 312 (only a portion is shown), individually electronically controlled valve 313, a one-way valve 330, a tray state sensor 380 and a leak detection sensor 381.

Continuing on this nonlimiting example, tray state sensor 380 is configured to detect a state of tray 311. Tray state sensor 380 may be configured to detect tray temperature, coolant temperature, humidity levels, and the like. For example, tray state sensor 380 may be configured to detect changes in temperature of tray. The sensed temperature is communicated to a controller (e.g., controller 106), which may send an electronic control signal to the valve 313 to control the opening state thereof based on the sensed temperature. For example, an increase in temperature detected by tray state sensor 380 may result in an increase in opening state of the individually electronically controlled valve 313 so as to increase the flow of coolant to the tray 311 and thereby cool tray 311. On the other hand, a decrease in temperature detected by tray state sensor 380 may result in a decrease in opening state of the individually electronically controlled valve 313 so as to decrease the flow of coolant to the tray 311 and thereby avoid wasteful overprovisioning of coolant. In examples, tray state sensor 380 may also detect a humidity level in the tray. The sensed humidity level may be communicated to a controller (e.g., controller 106), which may send an electronic control signal to the valve 313 to control the opening state thereof based on the sensed humidity level For example, if the humidity level exceeds a threshold, the controller may cause individually electronically controlled valve 313 to reduce its opening state so as to increase the temperature of the tray in order to reduce risk of mildew formation within tray 311.

Still on this nonlimiting example, leak detection sensor 381 may detect a leak within tray 311, and in response to detecting such a leak send a notification to a controller. The controller may, in response to the notification of the leak, cause individually electronically controlled valve 313 to set opening state to a fully closed position. This prevents additional liquid from flowing into the tray 311, thus preventing further liquid from leaking out.

The one-way valve 330 is provide on a downstream side of the tray 311, in this example, to prevent a back-flow of liquid from the return side of the coolant loop 312 into the tray 311. Such a back-flow of liquid might occur, if valve 330 was absent, when the valve 313 is fully closed, such as when a leak is detected.

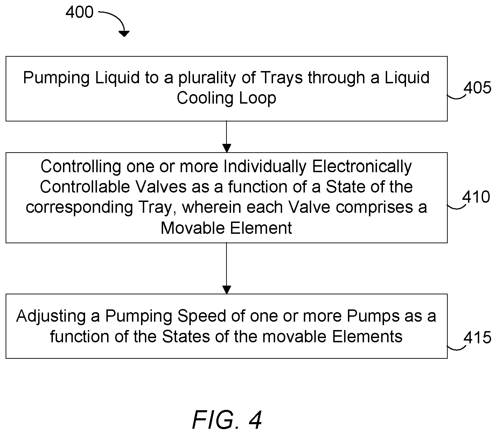

Now referring to FIG.4, a method 400 is presented. At step 405, method 400 in instances, includes pumping liquid, by one or more pumps 116, to a plurality of trays 111, each including one or more processors, through a liquid cooling loop 112.

Continuing to refer to FIG.4, in instances, at step 410, method 400 includes controlling, by at least one controller of cooling control system 100, one or more individually electronically controllable valves 113 as a function of a state of corresponding tray 111, wherein each valve of the one or more individually electronically controllable valves 113 includes movable element 114 which is movable in response to an electronic signal to control flow of the liquid coolant to a corresponding tray 111. For example, without limitations, method 500 may include increasing an opening state of movable element 114 of individually electronically controllable valves 113 based on an increase in internal temperature of the tray 111.

Still referring to FIG. 4, method 400, in instances, at step 415, includes adjusting, by the at least one controller of cooling control system 100, a pumping speed of the one or more pumps 116 based on the states of movable elements 114 of the plurality of individually electronically controllable valves 113. For example, without limitations, as opening state increases, pumping speed to meet the increased demand in also increased. Alternatively, as opening state decreases the pumping speed also decreases as to reduce the resources needed for circulating liquid coolant through cooling control system 100.

In instances, method 400 may include detecting, by at least a sensor, a leak at a given tray 111. In further instances, method 400 may include setting, by the at least one controller of cooling control system 100, the movable element 114 of the valve 113 corresponding to the given tray 111, out of the individually electronically controllable valves 113, to a fully closed position based on the detected leak. For example, without limitations, the least one controller of cooling control system 100 may stop pumping liquid coolant to a tray 111 as to prevent further leaks. In a nonlimiting example, in a case where a rear individually electronically controllable valve 113 configuration is used, the at least one controller of cooling control system 100 may send a signal to one or more pumps 116 to stop pumping when a leak is detected, while allowing movable element 114 to stay open as to allow fluid inside leaking tray to exit as to reduce liquid coolant leakage into the system.

Method 400, in instances, may include controlling one or more individually electronically controllable valves 113 based on a state prediction. In some instances, method 400 may include generating the state prediction. In instances, method 400 may include calculating a liquid flow delay rate between one or more pumps 116 and at least one individually electronically controllable valve 113. In some instances, method 400 may further include determining timings for adjusting the pumping speed of the one or more pumps 116 based on the liquid flow delay rate, where the pumping speed is adjusted according to the determined timings. For example, without limitations, method 400 may include adjusting pumping speed prior to controlling individually electronically controllable valve 113 by the determined timing.

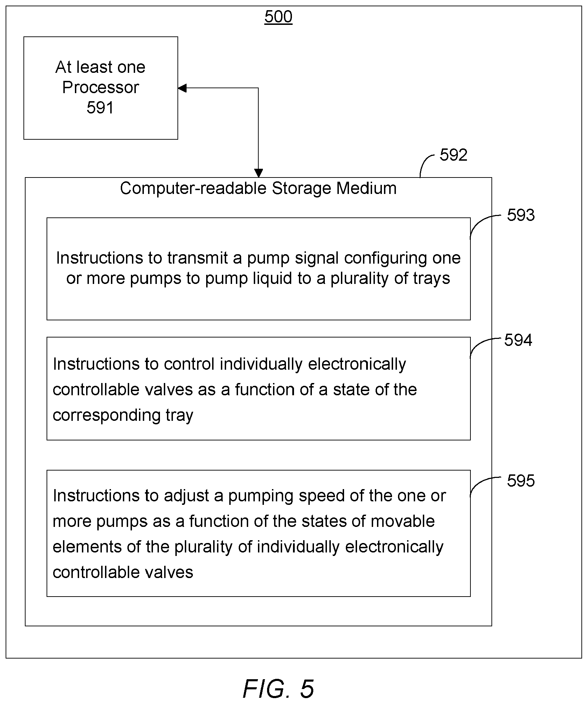

Now referring to FIG. 5, an example computing device 500 is presented. In this example, computing device 500 includes at least one processor 591 communicably coupled to a computer-readable storage medium 592. The at least one processor 591 may include a microprocessor, a microcontroller, one or more central processing unit (CPU) cores, an application-specific integrated circuit (ASIC), one or more graphical processing unit (GPU) cores, a field programmable gate array (FPGA), and/or any other hardware device suitable for retrieval and execution of instructions from computer-readable storage medium 592. In instances, the at least one processor 591 may include electronic circuitry for performing instructions described in this disclosure.

In instances, computer-readable storage medium 592 may be any medium suitable for storing executable instructions. In examples, without limitation, computer-readable storage medium 592 may include RAM, ROM, EEPROM, HHD, SSD, optical disc, and the like. Computer-readable medium storage 592 may be disposed within computing device 500. In instances, computer-readable storage medium 592 may external, and communicably connected, to computing device 500. The instruction stored on computer-readable storage medium may be used to implement method described in reference to FIG. 4.

Continuing to refer to FIG. 5, in this example computer-readable storage medium 592 is encoded with set of instructions 593-595. In instances, executable instructions included in each block may be included in different blocks shown and blocks not shown.

In instances, instruction 593, when executed by at least one processor 591, configures the at least one processor 591 to transmit a pump signal configuring one or more pumps 116 to pump liquid to a plurality of trays 111, each comprising one or more processors, through a liquid cooling loop 112.

In some instances, the instruction 594 further configure the processor to control, through at least one controller of cooling control system 100, one or more individually electronically controllable valves 113, where each individually electronically controllable valve 113 includes a movable element 114 which is movable in response to an electronic signal to control the flow of liquid coolant to a corresponding tray 111.

In instances, the instruction 595 further configures the at least one processor 591 to adjust, by the one or more controllers of cooling control system 100, a pumping speed of the one of more pumps 116 based on the states of the movable elements 114 of the individually electronically controllable valves 113.

In some instances, at least one processor 591 may further execute instructions to configure the at least one processor 591 to detect, by at least one sensor, a leak at a given tray 11, and set, by the least one controller of cooling control system 100, the movable element 114 of the valve 113 corresponding to the given tray 111 to a fully closed position based on the detected leak.

In instances, at least one processor 591 may further execute instructions to configure the at least one processor 591 to control one or more individually electronically controllable valves 113 based on a state prediction. In further instances, the instructions may further configure the processor to generate the state prediction.

In the description above, various types of electronic circuitry are described. As used herein, "electronic" is intended to be understood broadly to include all types of circuitry utilizing electricity, including digital and analog circuitry, direct current (DC) and alternating current (AC) circuitry, and circuitry for converting electricity into another form of energy and circuitry for using electricity to perform other functions. In other words, as used herein there is no distinction between "electronic" circuitry and "electrical" circuitry.

It is to be understood that both the general description and the detailed description provide examples that are explanatory in nature and are intended to provide an understanding of the present disclosure without limiting the scope of the present disclosure. Various mechanical, compositional, structural, electronic, and operational changes may be made without departing from the scope of this description and the claims. In some instances, well-known circuits, structures, and techniques have not been shown or described in detail in order not to obscure the examples. Like numbers in two or more figures represent the same or similar elements.

In addition, the singular forms "a", "an", and "the" are intended to include the plural forms as well, unless the context indicates otherwise. Moreover, the terms "comprises", "comprising", "includes", and the like specify the presence of stated features, steps, operations, elements, and/or components but do not preclude the presence or addition of one or more other features, steps, operations, elements, components, and/or groups. Components described as coupled may be electronically or mechanically directly coupled, or they may be indirectly coupled via one or more intermediate components, unless specifically noted otherwise. Mathematical and geometric terms are not necessarily intended to be used in accordance with their strict definitions unless the context of the description indicates otherwise, because a person having ordinary skill in the art would understand that, for example, a substantially similar element that functions in a substantially similar way could easily fall within the scope of a descriptive term even though the term also has a strict definition.

And/or: Occasionally the phrase "and/or" is used herein in conjunction with a list of items. This phrase means that any combination of items in the list-from a single item to all of the items and any permutation in between-may be included. Thus, for example, "A, B, and/or C" means "one of {A}, {B}, {C}, {A, B}, {A, C}, {C, B}, and {A, C, B}".

Elements and their associated aspects that are described in detail with reference to one example may, whenever practical, be included in other examples in which they are not specifically shown or described. For example, if an element is described in detail with reference to one example and is not described with reference to a second example, the element may nevertheless be claimed as included in the second example.

Unless otherwise noted herein or implied by the context, when terms of approximation such as "substantially," "approximately," "about," "around," "roughly," and the like, are used, this should be understood as meaning that mathematical exactitude is not required and that instead a range of variation is being referred to that includes but is not strictly limited to the stated value, property, or relationship. In particular, in addition to any ranges explicitly stated herein (if any), the range of variation implied by the usage of such a term of approximation includes at least any inconsequential variations and also those variations that are typical in the relevant art for the type of item in question due to manufacturing or other tolerances. In any case, the range of variation may include at least values that are within ±1% of the stated value, property, or relationship unless indicated otherwise.

Further modifications and alternative examples will be apparent to those of ordinary skill in the art in view of the disclosure herein. For example, the devices and methods may include additional components or steps that were omitted from the diagrams and description for clarity of operation. Accordingly, this description is to be construed as illustrative only and is for the purpose of teaching those skilled in the art the general manner of carrying out the present teachings. It is to be understood that the various examples shown and described herein are to be taken as exemplary. Elements and materials, and arrangements of those elements and materials, may be substituted for those illustrated and described herein, parts and processes may be reversed, and certain features of the present teachings may be utilized independently, all as would be apparent to one skilled in the art after having the benefit of the description herein. Changes may be made in the elements described herein without departing from the scope of the present teachings and following claims.

It is to be understood that the particular examples set forth herein are nonlimiting, and modifications to structure, dimensions, materials, and methodologies may be made without departing from the scope of the present teachings.

Aspects of the present disclosure may be defined by the following clauses:
1. A system, comprising:
   a computing system a plurality of trays each comprising one or more processors;
   a liquid cooling loop configured to supply liquid coolant to the plurality of trays;
   a plurality of individually electronically controllable valves disposed in the liquid cooling loop, wherein each valve of the one or more individually electronically controllable valves comprises a movable element which is movable in response to an electronic signal to control the flow of the liquid coolant to a corresponding tray of the plurality of trays;
   one or more pumps configured to cause the liquid coolant to flow through the liquid cooling loop;
   a control system comprising one or more controllers, wherein the one or more controllers are configured to:
      individually control each valve of the plurality of individually electronically controllable valves as a function of a state of the corresponding tray; and
      control the pumping speed of the one or more pumps as a function of the states of the movable elements of the plurality of individually electronically controllable valves.
2. The system of clause 1, wherein the control system is configured to monitor for leaks and, in response to detecting a leak at a given tray of the plurality of trays, set the movable element of the valve corresponding to the given tray, out of the plurality of individually electronically controllable valves, to a fully closed position.
3. The system of clause 1, wherein the one or more pumps comprise a rack level pump.
4. The system of clause 1, wherein the one or more pumps comprise a row level pump.
5. The system of clause 1, wherein the one or more pumps comprise a facility level pump.
6. The system of clause 1, further comprising one or more one-way valves disposed on a return flow associated with their respective individually electronically controllable valves.
7. The system of clause 1, wherein the control system is configured to control one or more valves of the plurality of individually electronically controllable valves as a function of a state prediction.
8. The system of clause 7, wherein the state prediction comprises a predicted status of a tray.
9. The system of clause 7, wherein the control system is further configured to generate the state prediction.
10. The system of clause 1, wherein the plurality of individually electronically controllable valves comprise a one-way valve.
11. A cooling method, comprising:
   pumping liquid coolant, by one or more pumps, to a plurality of trays, each
   comprising one or more processors, through a liquid cooling loop;
   controlling, by at least one controller of a control system, one or more individually electronically controllable valves as a function of a state of the corresponding tray, wherein each valve of the one or more individually electronically controllable valves comprises a movable element which is movable in response to an electronic signal to control the flow of the liquid coolant to a corresponding tray of the plurality of trays; and
   adjusting, by the at least one controller of the control system, a pumping speed of the one or more pumps as a function of the states of the movable elements of the plurality of individually electronically controllable valves.
12. The method of clause 11, wherein the method comprises:
   detecting, by at least a sensor, a leak at a given tray of the plurality of trays; and setting, by the at least one controller of the control system, the movable element of the valve corresponding to the given tray, out of the plurality of individually electronically controllable valves, to a fully closed position as a function of the detected leak.
13. The method of clause 11, wherein the method further comprises controlling one or more valves of the plurality of individually electronically controllable valves as a function of a state prediction.
14. The method of clause 13, further comprising generating the state prediction.
15. The method of clause 11, wherein the method further comprises calculating a liquid flow delay rate between one or more pumps and at least one valve of the plurality of individually electronically controllable valves.
16. The method of clause 15, further comprising determining timings for adjusting the pumping speed of the one or more pumps as a function of the liquid flow delay rate, wherein the pumping speed is adjusted according to the determining timings.
17. A non-transitory computer-readable medium storing instructions, when executed by at least one processor, configuring the at least one processor to:
   transmit a pump signal configuring one or more pumps to pump liquid coolant to a plurality of trays, each comprising one or more processors, through a liquid cooling loop;
   control, through at least one controller of a control system, one or more individually electronically controllable valves as a function of a state of the corresponding tray, wherein each valve of the one or more individually electronically controllable valves comprises a movable element which is movable in response to an electronic signal to control the flow of the liquid coolant to a corresponding tray of the plurality of trays; and
   adjust, through the at least one controller of the control system, a pumping speed of the one or more pumps as a function of the states of the movable elements of the plurality of individually electronically controllable valves.
18. The non-transitory computer-readable medium storing instructions of clause 17, wherein the at least one processor is further configured to:
   detect, by at least a sensor, a leak at a given tray of the plurality of trays; and set, by the at least one controller of the control system, the movable element of the valve corresponding to the given tray, out of the plurality of individually electronically controllable valves, to a fully closed position as a function of the detected leak.
19. The non-transitory computer-readable medium storing instructions of clause 17, wherein the at least one processor is further configured to control one or more valves of the plurality of individually electronically controllable valves as a function of a state prediction.
20. The non-transitory computer-readable medium storing instructions of clause 19, wherein the at least one processor is further configured to generate the state prediction.

Other examples in accordance with the present disclosure will be apparent to those skilled in the art from consideration of the specification and practice of the invention disclosed herein. It is intended that the specification and examples be considered as exemplary only, with the following claims being entitled to their fullest breadth, including equivalents, under the applicable law.

## Claims

1. A system, comprising:
a computing system a plurality of trays each comprising one or more processors;
a liquid cooling loop configured to supply liquid coolant to the plurality of trays;
a plurality of individually electronically controllable valves disposed in the liquid cooling loop, wherein each valve of the one or more individually electronically controllable valves comprises a movable element which is movable in response to an electronic signal to control the flow of the liquid coolant to a corresponding tray of the plurality of trays;
one or more pumps configured to cause the liquid coolant to flow through the liquid cooling loop;
a control system comprising one or more controllers, wherein the one or more
controllers are configured to:
individually control each valve of the plurality of individually electronically controllable valves as a function of a state of the corresponding tray; and
control the pumping speed of the one or more pumps as a function of the states of the movable elements of the plurality of individually electronically controllable valves.

2. The system of claim 1, wherein the control system is configured to monitor for leaks and, in response to detecting a leak at a given tray of the plurality of trays, set the movable element of the valve corresponding to the given tray, out of the plurality of individually electronically controllable valves, to a fully closed position.

3. The system of claim 1, wherein the one or more pumps comprise a rack level pump, a row level pump, or a facility level pump.

4. The system of claim 1, further comprising one or more one-way valves disposed on a return flow associated with their respective individually electronically controllable valves.

5. The system of claim 1, wherein the control system is configured to control one or more valves of the plurality of individually electronically controllable valves as a function of a state prediction.

6. The system of claim 5, wherein the state prediction comprises a predicted status of a tray.

7. The system of claim 5, wherein the control system is further configured to generate the state prediction.

8. A cooling method, comprising:
pumping liquid coolant, by one or more pumps, to a plurality of trays, each comprising one or more processors, through a liquid cooling loop;
controlling, by at least one controller of a control system, one or more individually electronically controllable valves as a function of a state of the corresponding tray, wherein each valve of the one or more individually electronically controllable valves comprises a movable element which is movable in response to an electronic signal to control the flow of the liquid coolant to a corresponding tray of the plurality of trays; and
adjusting, by the at least one controller of the control system, a pumping speed of the one or more pumps as a function of the states of the movable elements of the plurality of individually electronically controllable valves.

9. The method of claim 8, wherein the method comprises:
detecting, by at least a sensor, a leak at a given tray of the plurality of trays; and setting, by the at least one controller of the control system, the movable element of the valve corresponding to the given tray, out of the plurality of individually electronically controllable valves, to a fully closed position as a function of the detected leak.

10. The method of claim 8, wherein the method further comprises controlling one or more valves of the plurality of individually electronically controllable valves as a function of a state prediction, wherein the method optionally further comprises generating the state prediction.

11. The method of claim 8, wherein the method further comprises calculating a liquid flow delay rate between one or more pumps and at least one valve of the plurality of individually electronically controllable valves.

12. The method of claim 11, further comprising determining timings for adjusting the pumping speed of the one or more pumps as a function of the liquid flow delay rate, wherein the pumping speed is adjusted according to the determining timings.

13. A non-transitory computer-readable medium storing instructions, when executed by at least one processor, configuring the at least one processor to:
transmit a pump signal configuring one or more pumps to pump liquid coolant to
a plurality of trays, each comprising one or more processors, through a liquid cooling loop;
control, through at least one controller of a control system, one or more
individually electronically controllable valves as a function of a state of the corresponding tray, wherein each valve of the one or more individually electronically controllable valves comprises a movable element which is movable in response to an electronic signal to control the flow of the liquid coolant to a corresponding tray of the plurality of trays; and
adjust, through the at least one controller of the control system, a pumping speed
of the one or more pumps as a function of the states of the movable elements of the plurality of individually electronically controllable valves.

14. The non-transitory computer-readable medium storing instructions of claim 13, wherein the at least one processor is further configured to:
detect, by at least a sensor, a leak at a given tray of the plurality of trays; and set, by the at least one controller of the control system, the movable element of the valve corresponding to the given tray, out of the plurality of individually electronically controllable valves, to a fully closed position as a function of the detected leak.

15. The non-transitory computer-readable medium storing instructions of claim 13, wherein the at least one processor is further configured to control one or more valves of the plurality of individually electronically controllable valves as a function of a state prediction, wherein the at least one processor is optionally further configured to generate the state prediction.
